# EUROPEAN PATENT APPLICATION

(11) **EP 2 538 437 A1**
(43) Date of publication of application: **26.12.2012**
(21) Application number: 11171192.5
(22) Date of filing: 23.06.2011
(51) Int. Cl.: H01L 21/673, B28D 5/00

(54) **Holding device for holding an arrangement of a plurality of wafers**

(71) Applicant: Meyer Burger AG, 3600 Thun (CH)
(72) Inventor: Schnyder, Matthias, 3604 Thun (CH); Wenger, Andrew, 3612 Steffisburg (CH)
(74) Representative: Künsch, Joachim

(57) **Abstract**

The invention relates to a holding device (1) for holding an arrangement (7) of a plurality of wafers, the holding device (1) comprises:
a receiving space (2) for receiving said arrangement (7) of a plurality of wafers,
at least two holding members (3), which are arranged on opposite sides of said receiving space (2), and
a support structure (4), on which the holding members (3) are arranged,
wherein at least one of the holding members (3) is movable with respect to said support structure (4) to bring the holding device (1) from a releasing state to a holding state, in which a holding force is applied by the holding members (3) against the sides of said wafers.

## Description

The invention relates to a holding device for holding an arrangement of a plurality of wafers, a method of receiving an arrangement of a plurality of wafers from a processing device and a method for treating of wafers in a holding device.

Wafers e.g. for use in solar cells are cut from a block (also called brick or ingot) in a wire cutting device employing a metal wire and abrasives. Usually abrasives suspended in a slurry, that are transported by a metal wire, are used. Nowadays, wafers are cut more and more using fixed abrasives, which are directly attached to the metal wire. Such wire is e.g. called a diamond wire. Wafers can also be made of other materials such as sapphire. In case, the block is generally referred to as core.

From prior art containers are known for receiving a wafer already cut into a plurality of individual wafers. When the wafers are still basically in the position they were in before they were cut, the wafers are called a wafer block. The containers are used to clean or otherwise treat the wafers.

Prior art is further known, where the block to be cut is attached to a glass plate, which in turn is attached to a fixture attachment. The fixture attachment is horizontally inserted between two guide rails (usually L-shaped). The guide rails are part of the cutting device and only used for inserting the workpiece into the machine. As soon as the workpiece is in position, clamps hold the fixture attachment during cutting. When the cutting process is finished, the wafer block (arrangement of a plurality of parallel wafers) is slid out of the cutting device, while the fixture attachment is supported by the two guide rails.

Due to the fact, that the load is pretty heavy, the relative motion of the guide rails, the fixture attachment and the dirt (slurry) in between produces friction that is irregular and pretty hard to overcome. Moreover, when moving the block into and out of the cutting device or during transportation, the block wobbles (e.g. slip-stick effect). In the case of the inward movement this does not constitute a problem, since the block has not been cut yet. However, when removing said wafer block comprising a plurality of extremely thin wafers, the so called slip-stick effect causes damages to the wafers. The individual wafers tilt easily about the axis formed by the thin attachment zone on the glass plate or the fixture attachment, respectively. This causes adjacent wafers to touch each other. When the wafers however touch each other they may be damaged. Hence the slip-stick effect causes yield loss, resulting in higher costs per wafer.

The object of the invention is to overcome these problems and to provide a holding device and method for using the holding device which minimizes the disadvantageous effects of movement, as e.g. the slip stick effect. The inventive solution guarantees, that the wafers of the wafer arrangement are not damaged during detachment from a processing device, e.g. a cutting device, during transport and/or during various treating processes.

This object is achieved by a holding device for holding an arrangement of a plurality of wafers, the holding device comprises:
a receiving space for receiving said arrangement of a plurality of wafers,
at least two holding members, which are arranged on opposite sides of said receiving space, and
a support structure, on which the holding members are arranged,
wherein at least one of the holding members is movable with respect to said support structure to bring the holding device from a releasing state into a holding state, in which a holding or positioning force is applied by the holding members against the side edges of said wafers.

At least one of the holding members is adapted to move towards the other thereby exerting a force onto the sides of the wafers in order to hold them in position. By bringing holding members onto the wafers, the wafers are held in a defined manner. The holding members give the wafers stability by holding them from the sides and protects them from damage. In order to optimally receive the wafer arrangement and to achieve a symmetrical movement of the holding members, both holding members are movably arranged on the support structure.

Usually a holding member has an extension as to abut against all wafers. So, the length of that holding member corresponds to the length of said wafer arrangement or extends beyound the length of said wafer arrangement.

In an embodiment the holding device comprises a transmitting means which is in co-acting communication with a holding member and adapted to co-act with the arrangement of a plurality of wafers and to cause the holding member to apply a holding force against the sides of said wafers, when the arrangement of a plurality of wafers is brought into said receiving space. With this embodiment the holding members are automatically brought in the holding position. The transmitting system may be formed of mechanical, pneumatic, hydraulic or electric transmitting means.

In another embodiment the transmitting means comprises a contact member which is adapted to contact the arrangement of a plurality of wafers, when the arrangement of a plurality of wafers is brought into said receiving space, and wherein the contact member is preferably made of a soft and/or elastic material. The contact member allows a simple and efficient co-action with the wafer arrangement or its carrier. The weight of the wafer block may be used to press the holding members onto the wafers.

In another embodiment said transmitting means is adapted to transmit a force applied to the contact member by the arrangement of a plurality of wafers onto the holding members, and wherein the transmitting means preferably comprise a mechanical and/or pneumatic and/or hydraulic transmission path. The transmitting means is able to receive a force from the wafer arrangement and to transmit the force onto the holding members.

In another embodiment said contact member is arranged in the bottom region of said holding device for contacting the lower side of the wafers, when the arrangement of a plurality of wafers is received by said receiving space. The contact member has then two functions: acting as part of the transmitting means and supporting - and thus additionally fixing - the wafers.

In another embodiment said contact member is arranged laterally in the top region of the holding device for contacting a carrier of the arrangement of a plurality of wafers, when the arrangement of a plurality of wafers is received by said receiving space. In this embodiment the carrier actuates the transmitting means. The contact member serves as support for the carrier.

In another embodiment said transmitting means comprise a lever which is pivotably mounted on the support structure, and wherein preferably the lever is L-shaped. A lever is a simple and maintenance-free means for transmitting forces.

In another embodiment the transmitting means is adapted to be forced into the releasing state by gravity, when there is no arrangement of a plurality of wafers received by said receiving space. This is an elegant way to bring the holding means 3 in its releasing position.

In another embodiment the transmitting means communicates with a spring means, forcing the transmitting means into the releasing position, when there is no arrangement of a plurality of wafers received by said receiving space.

In an embodiment the holding device comprises a fixing means for fixing the transmitting means or the holding members in their holding state. This is advantageous when subsequently removing the individual wafers form the wafer arrangement. The pressing force of the wafer arrangement onto the transmitting means reduces, by removing wafers. The fixing means guarantees that the holding position is maintained anyway and that the pressing force is automatically controlled to a proper value, independent on the quantity of wafers still held in the wafer arrangement.

In another embodiment the holding device comprises an counteracting means for partially counteracting the holding force applied by the holding members against the side of the wafers, and wherein preferably the counteracting means are in direct communication with the transmitting means. With the aid of the counteracting means the holding force may be reduced to a certain amount. This may be advantageous during certain treating steps, e.g. cleaning. The requirements for the holding device ask for different clamping forces of the wafers, e.g. a stronger clamping force is required during transportation in comparison to a cleaning step, where a partially released force is desired. A holding force is needed to hold them firm for discharging and the transport to a (pre-)cleaning station. A different holding force is required to hold them a bit less firm during the process of pre-cleaning and for separation of the wafers from the fixture attachment. This may be achieved by a force counteracting the holding force. In one embodiment pins (possible with a spring element) are provided, that extend from the bottom of the container. As the holding device is placed on a solid base, the pins are pushed inwards lifting the transmitting means (eg: lever, cranks, connection rods, partially acting on valves) and partially releasing the holding force. This position is needed for the pre-cleaning and the separation step.

In another embodiment the holding device comprises a stop for limiting the receiving movement of the arrangement of a plurality of wafers into the receiving space by abutting against a carrier of the arrangement of a plurality of wafers. The wafer arrangement takes a defined position within the holding device. This is for example useful when wafers are removed from the carrier one by one. Since the mass of the wafer block is reduced, so is the pressure on the wafers.

In another embodiment the holding members are formed from a soft, preferably elastic material and/or wherein the holding members are formed from a roller, which is rotatable about its axis. This feature helps to protect the wafers.

In another embodiment the at least one of the holding members is movable by inflatable means. Due to their flexibility inflatable means further protect the wafers. The may be inflated by gaseous or liquid fluids.

In another embodiment the contact member is constituted or formed by a second inflatable profile, which is in pneumatic or hydraulic communication with said first inflatable means.

In another embodiment the support structure is a container for enclosing the wafers. This container further protects the wafers and allows for additional process steps, as e.g. cleaning in a fluid or in a ultrasonic bath.

The invention also relates to a method of receiving an arrangement of a plurality of wafers from a processing device, particularly a cutting device for cutting a plurality of wafers from a block, using a holding device, wherein the method comprises the steps of:
bringing the holding device in a position relative to the processing device as to receive the arrangement of a plurality of wafers,
bringing the holding members into the holding state, thereby applying a force against the sides of the wafers, and
detaching the arrangement of a plurality of wafers from the processing device. This method is used for securely unloading a wafer block from a processing device, where the holding device is placed around the wafers, pressing means press onto the wafers as to fix their position relative to the holding device and removing the holding device together with the wafers in the fixed position from the machine.

In an improved embodiment the holding device is brought into contact with a carrier of the arrangement of a plurality of wafers during receiving of said arrangement by the holding device. In this embodiment the holding device is brought into contact with the wafer block carrier or fixture attachment as to position it relative to the holding device.

The invention also relates to a method of treating of wafers in a holding device, wherein the wafers are held by holding members of the holding device, thereby applying a holding and positioning force against the sides of the wafers, and wherein the holding and positioning force is partially released for a certain amount before or during the treating process. This makes the wafers more flexible during application of cleaning fluids, streams, bubbles, heating, etc. This flexibility reduces the danger of breaking or damaging the wafers.

In a further embodiment at least one holding member is moved towards the wafers with an L-cranks system. As soon as the load is moved into the holding device, the lower side of the wafer touches the L-crank, thereby moving the holding member towards the wafer. The contact points of the L-cranks with the wafer are provided with a soft (eg. foam or sponge) material which cannot damage the wafers.

As the contact members (the parts that touch the wafers are all made of some sort of soft material) eventually wear down, the holding members will be pushed onto the wafers with the same force. The holding force depends on the shape of the cranks, their pivoting point and the mass of the wafer block (arrangement formed by the wafers when they basically are in the position after having been cut).

A spring may be provided that opens the cranks. Alternatively the mass of the cranks and their pivoting point may be chosen such that when left to move freely, they open on its own weight. This means that an appropriate spatial weight distribution of the lever around the hinge has to be found.

As long as the holding device is positioned in the telescopic rail for the charging and discharging of the cutting device or during the transport between the different work steps the firm clamp position is guaranteed.

To avoid that the force of the tension spring opens the L-crank or any other type of lever during separation (one wafer after another is removed from the wafer block and the force on the cranks is thus reduced gradually), fixation means may be provided that fixate the cranks. Since the exact position of the cranks depends on the mass of the wafer block and the wear of the soft elements touching the wafer block, the fixation means preferably are independent on the exact position of the cranks. In this case the fixation means may comprise an electro-magnet, a friction element (screws, leaver) or a number of holes in the cranks cooperating with a hole in the support structure of the holding device that can receive a pin. In its simplest form, the cranks can only be fixed in one position by similar means.

In a further improved embodiment the soft elements are covered with a wear resistant material e.g. Teflon ® of Dupont or other plastic in order to reduce wear.

Means may be provided to apply a holding force manually (knob, screw, etc.) or automatically (hydraulic, pneumatic, motor, etc.). In the former case, it is preferred that the means are accessible from the front side of the holding device, where it is easiest to access. In this way, the system is self-contained, like the solution with the L-cranks.

Supporting means or stops may be provided that support the fixture attachment or any other member attached to the wafers as to delimit the downward movement of the wafer block.

The inventive idea can be used for receiving and holding wafers of any kind: mono-and polycrystalline; with circular, rectangular or other shapes; from silicon, boron, sapphire or any other material; for use in semiconductor technology, photovoltaic, LED-production, etc..

Further embodiments of the invention are indicated in the figures and in the dependent claims. The list of reference marks forms part of the disclosure. The invention will now be explained in detail by the drawings. In the drawings:
Fig. 1 shows a cutting device for cutting wafers from a block,
Fig. 2 shows the attachment of the wafer arrangement on the cutting device,
Fig. 3 shows parallel arranged wafers after the cutting process,
Fig. 4 shows wafers after the cutting process with some of the wafers have fallen sideways (prior art),
Fig. 5 shows a holding device according to the invention,
Fig. 6 shows the holding device of Fig. 5 receiving an arrangement of a plurality of wafers,
Fig. 7 shows an embodiment of the holding device,
Fig. 8 shows an embodiment of the holding device with a counteracting means,
Fig. 9 shows an embodiment of the holding device with adjusting knobs for moving the holding members,
Fig. 10 shows schematically an embodiment of the holding device with inflatable holding members,
Fig. 11 shows in detail an extending member of the carrier.

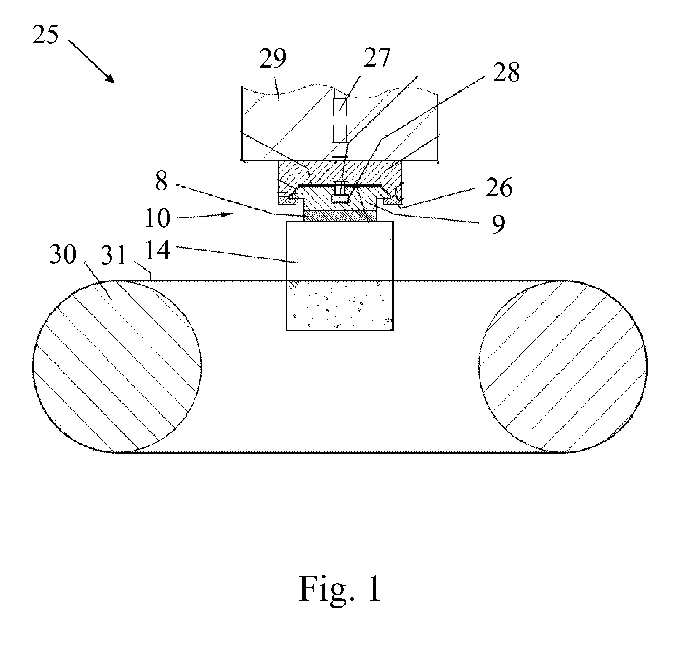

Fig. 1 shows, as an example of a processing device 25, a cutting device for cutting a plurality of wafers from a block 14 (also called brick, ingot or core). The cutting device comprises a support base 29 for positioning block 14 with respect to a cutting wire 31. Block 14 is attached, usually glued, to a glass plate 8, which in turn is attached to a fixture attachment 9 usually made of metal. Glass plate 8 and fixture attachment 9 form the block carrier or wafer carrier 10 - depending on the stage of the process - which is detachable from the cutting device 25. The fixture attachment 9 is used for connecting the carrier 10 with the support base 29. In the present embodiment this is accomplished by two horizontal guide rails 26 extending downwardly form the support base 29. A telescopic support with tensioning rod 27 with a mounting surface 28 is provided for vertically fixating said block 14. Cutting device 25 further comprises wire guide rolls 30 for forming a field of cutting wire 31.

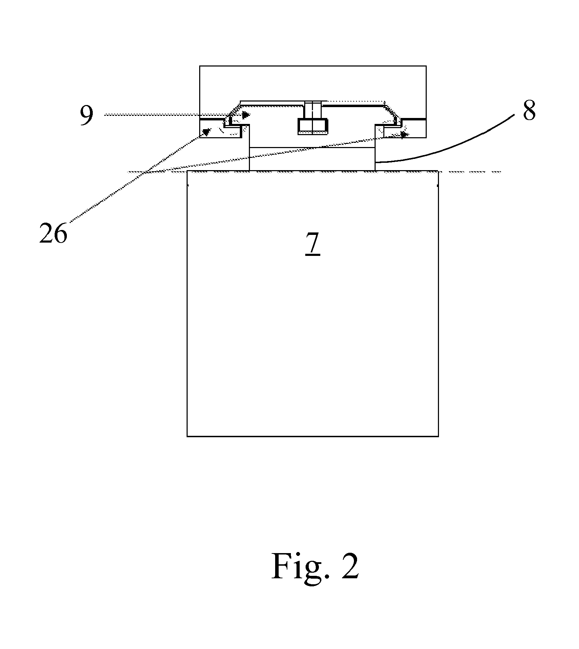

Fig. 2 shows in detail the connection of the fixture attachment 9 to the wire saw.

After all cuts for separating the wavers have been made (all wafers are cut in parallel), the wafers are still attached to the glass plate 8 giving the wafer block a comb-like structure.

During the cutting process, the block 15 is pushed through the wire field, causing the sawing wire 31 to bend downwards (not shown). Because of this bow of the sawing wire, the top edges of the block are cut before the middle part of the block is completely cut. It is the purpose of the glass plate 8 to keep the fixture attachment 9 at a distance of the block 14, so that the fixture attachment 9 is not cut. The glass plate 8 - which is relatively inexpensive - is replaced after each cut.

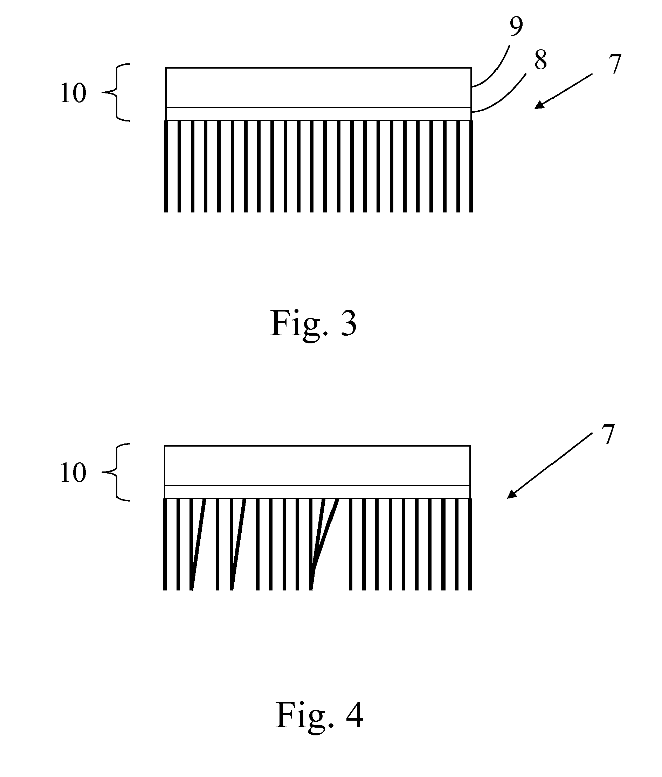

Once the wafers have been cut, the fixture attachment 9, glass plate 8 and the arrangement 7 of a plurality of wafers are removed from the cutting device and the wafers have to be cleaned and separated from the glass plate 8. Ideally, the arrangement 7 of a plurality of wafers corresponds to the drawing of Fig. 3. All wafers are aligned in parallel with a constant spacing between the individual wafers. However, the wafers are very thin and easily damaged. One can imagine, that if the fixture attachment 9 is tilted or pushed, the wafers move sideward and stick to each other due to the fluid on their respective surfaces forming the spacing between them. Fig. 4 illustrates this non-ideal situation according to the prior art.

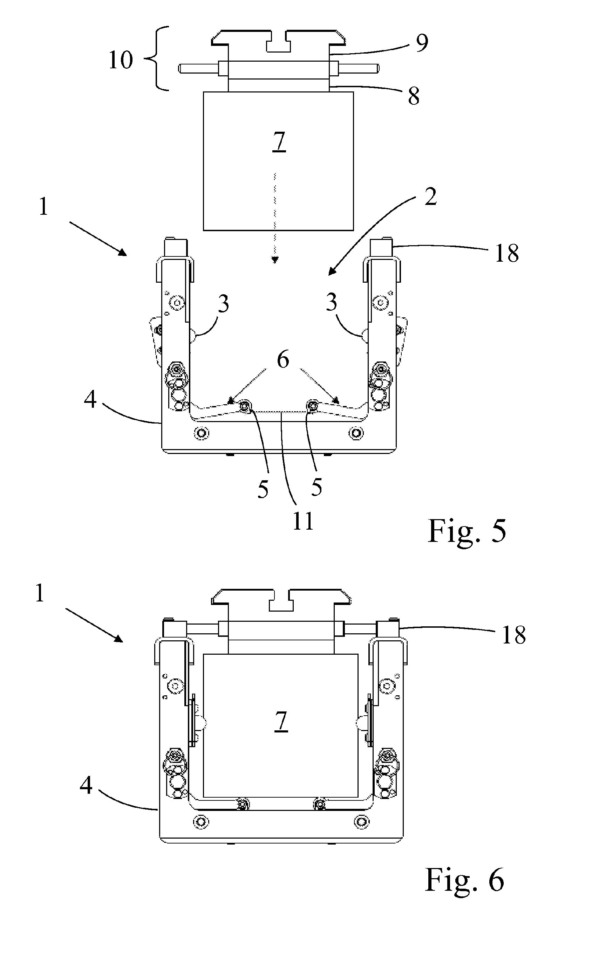

Fig. 5 shows an embodiment of a holding device 1 according to the invention. Holding device 1 of Fig. 5 comprises a receiving space 2 for receiving an arrangement 7 of wafers, a support structure 4 in form of a container which encloses said receiving space 2 and two holding members 3, which are connected to the support structure 4 and arranged on opposite sides of said receiving space 2.

Holding members 3 are movable with respect to the support structure 4. The distance between the holding members 3 can be changed by moving the holding members 3 in opposite direction. Without a wafer arrangement 7 being inserted into the holding device 1, the holding members 3 are in a releasing (or receiving) position (Fig. 5). If a wafer arrangement 7 is received by the holding device 1 - as shown in Fig. 6 - the holding members 3 are moved towards each other (the distance between the holding members 3 reduces) and the holding device 1 is brought into a holding state, in which a holding and positioning force is applied by the holding members 3 against the sides of said wafers.

In order to securely unload the wafer arrangement 7 from a processing device, e.g. a cutting device or a cleaning device, the following steps are performed: bringing the holding device 1 in a position relative to the processing device as to receive the wafer arrangement 7, bringing the holding members 3 into the holding state, thereby applying a force against the sides of the wafers, and subsequently detaching the wafer arrangement 7 from the processing device.

The wafer arrangement 7 with its carrier 10 is detached from the processing device not until the wafers are fixedly held by the holding members 3 in the holding position. According to the inventive solution, the wafers are securely held when removing them from the processing device and during transfer to a subsequent processing device (e.g. into a cleaning station). After cutting, the wafer arrangement 7 is usually transferred to a cleaning device for removing slurry/cutting fluid, sawdust and the glue used for gluing the block 14 to the glass plate 8. The aim of the inventive method is to avoid moving the wafers relative to the glass plate before they are released from that glass plate. This is done by holding the wafers and preferably the glass plate while handling the wafer block, particularly, when unloading the cutting machine. With such a method the yield loss is reduced and the charging and discharging cycle is improved. Situations as illustrated in Fig. 4 are avoided.

The holding device of figs. 5 and 6 has further advantages. When being received by the receiving space 2 the wafers touch with their lower sides (opposite to the sides which are attached to glass plate 8 and fixture attachment 9) two contact members 5, which in turn move downwards by the force caused by the weight of the wafer arrangement 7. Each contact member 5 is part of a transmitting means, which is in co-acting communication with a holding member 3. The transmitting means is adapted to co-act with the wafer arrangement 7 so as to cause the holding member 3 to apply a particular holding force against the sides of said wafers, when the wafer arrangement 7 is brought into the receiving space 2. In the embodiment of figs. 5 and 6 the contact members 5 are each situated on an end of an L-shaped lever 6 (sometimes also called crank) which is pivotably mounted on the support structure 4. The holding members 3 are situated on the other end of said lever 6. A downward movement of the contact members 5 therefore causes the lever 6 to pivot and the holding members 3 to press against the wafers. In an alternate embodiment it would suffice to have only one movable holding member 3. The other one could be fix relative to support structure 4.

In this embodiment the holding position is automatically reached just by receiving the wafer arrangement 7. When removing the wafer arrangement 7, the holding means 3 are brought into the releasing position by spring means 11 which connect the two levers 6 at their bottom ends. It would be also possible to design the transmitting means (e.g. contact members and levers) and positioning their hinge such that a corresponding weight distribution brings the holding members 3 into the releasing position by gravity.

Holding device 1 further comprises a stop 18 or support for the carrier 10 of the wafers. As shown in fig. 6 the fixture attachment 9 of the carrier 10 abuts against the stop 18, which has one or more grooves for receiving members extending from said fixture attachment 9. The stops 18 avoid that the full weight of the wafer arrangement 7 is carried by the extremely thin wafers, when being received by the holding device 1.

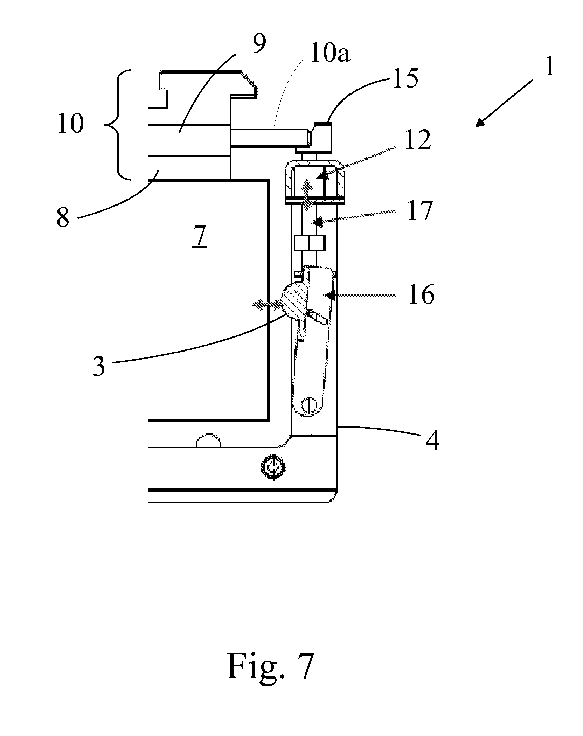

Fig. 7 shows an alternative embodiment of a holding device 1. The contact members 15 are arranged laterally in the top region of the support structure 4. In the receiving position the contact members would be near to the glass plate 8 and fixture attachment 9. The contact members 15 have two functions: they are part of the transmitting means for bringing the holding members 3 into the holding position, and they act as a stop for the receiving movement of the wafer arrangement 7. As can be seen from Fig. 7, extending member 10a of the carrier 10 abuts with its fixture attachment 9 against the contact member 15. Contact member 15 is pressed downwards against a connection rod 17 by the weight of the wafer block. Connection rod 17 communicates via a link guide with a lever 16, which is forced to pivot about its hinge connected to the support structure 4. Due to the pivoting motion of the levers 16, the holding members 3 are pressed from opposite sides against the wafers. A spring 12 - acting on the contact member 15 or another part of the transmitting means - is provided as to force the contact member 15 and thus the hole transmission means into the releasing position, when the wafer arrangement 7 is removed from the holding device 1. Moreover: when there is no wafer block in the holding device 1, the connection rod is reset by a pressure spring moving the rod in upward.

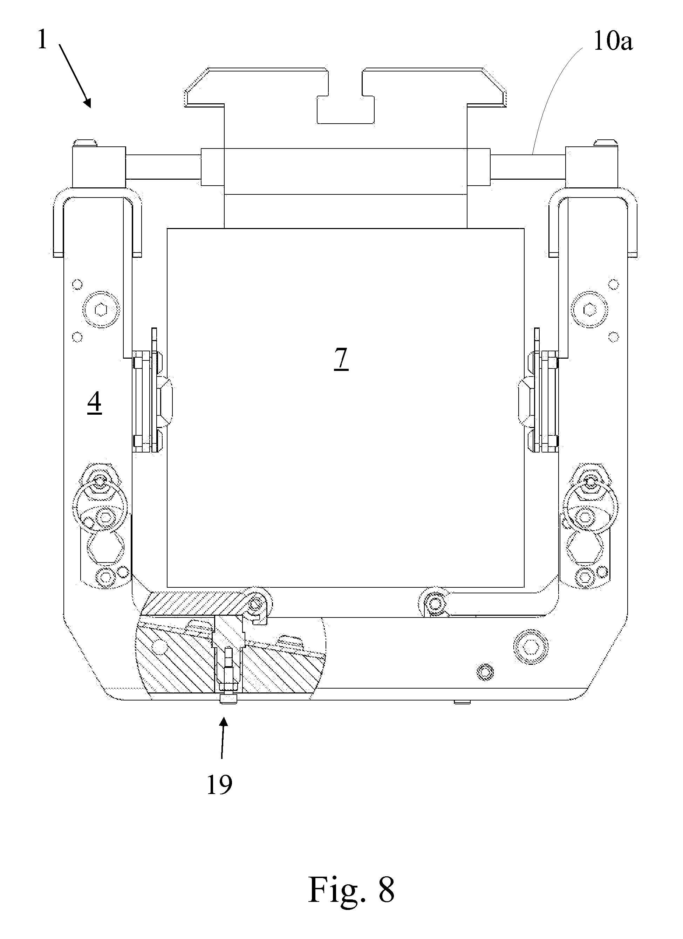

Fig. 8 shows a further embodiment revealing a special feature concerning the strength of the applied holding force.

Holding device 1 comprises a counteracting means for partially counteracting the holding force applied by the holding members 3 against the side of the wafers. The counteracting means are in direct communication with the lever 6 of the transmitting means. With the aid of the counteracting means the holding force may be reduced to a certain amount. This may be necessary during certain treating steps, e.g. cleaning. In the present embodiment pins 19 (possibly co-acting with a spring element pushing it up, when no wafer block is present in the holding device 1, not shown in fig 8) are provided as counteracting means, that extend downwardly from the bottom of the support structure 4. The weight of the wafer block 7 forces the pin downward. As the holding device 1 is placed on a solid base, e.g. a table or the like, the pins 19 are pushed inwards, thereby lifting the lever 6 and partially (or fully if desired) releasing the holding force. It is of course possible to use other means for reducing the holding force. They may be manually adjustable by screws, knobs, or by electrical control, etc..

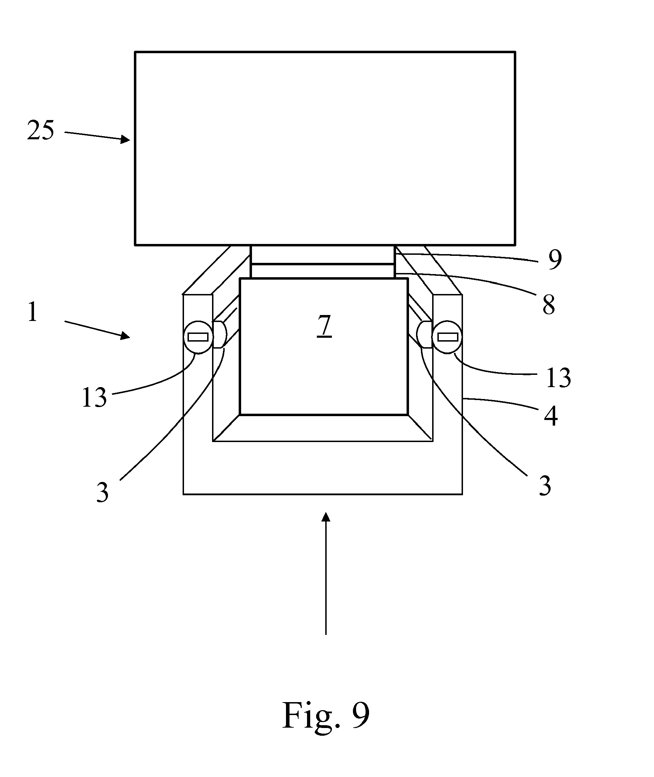

Fig. 9 shows a further embodiment of a holding device 1, which is brought in a relative position with respect to a processing device 25 as to receive the wafer arrangement 7. In this embodiment holding members 3 are formed of longitudinal bars extending along opposite side walls of the container 4. Turnable adjusting knobs 13 are provided at the front of the container walls of the support structure 4. Adjusting knobs 13 are in co-acting communication with the holding members 3. Fig. 9 is an example of manually adjustable holding members, i.e. the movement of the holding members 3 towards their holding position (and back to the releasing position) is accomplished by the operator. In the present embodiment an easy operation may be performed by a simple screw driver to be inserted into a slit of knob 13. Of course, alternative mechanisms of manually moving the holding members 3 are possible, e.g. by a pushing knob/rod, a lever mechanism, electric means (motors, solenoids, etc.) activated by a button, or the like.

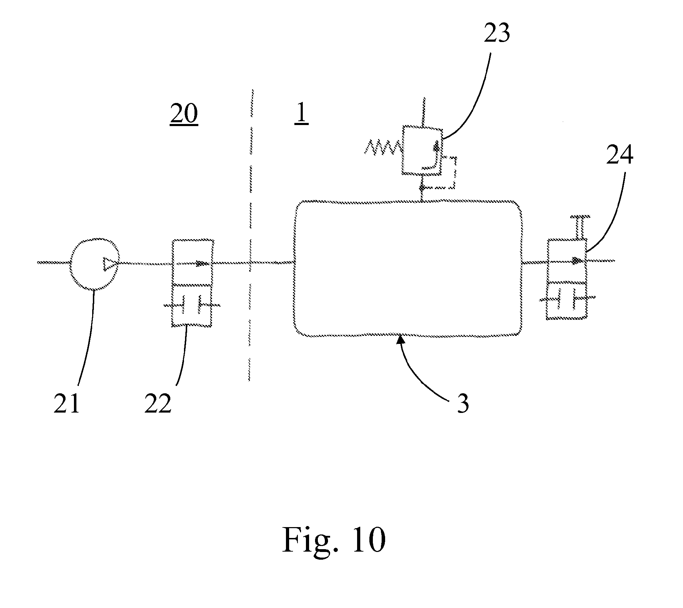

Fig. 10 shows schematically a further embodiment of a holding device 1. In the right part of Fig. 10, holding device 1 is indicated. For simplicity, only one holding member 3 is shown. However, it has to be understood, that a second holding member is provided in an opposite position as to receive a wafer arrangement 7 in between. Holding member 3 of Fig. 10 is part of an inflatable means or inflatable profile, e.g. a longitudinal hose or tube, a pad, cushion, etc., which is preferably formed from a polymer material, e.g. a flexible and/or elastic or plastic (plastically deformable). By inflating the inflatable means, the wafers are clamped by the pressure exerted by opposing holding means. As soon as the wafer arrangement 7 is positioned in the holding device 1, the profile is inflated and clamps the wafers. The profile may be inflated using a compressor 21 of an external pressure supply means 20 - as shown in Fig. 10 - or by the weight of the wafer arrangement 7.

In both cases, a pressure control valve 23 may be used in communication with said inflatable profile to prevent the pressure in the inflatable profile and thus the force on the wafers from becoming too large. A second control valve 24, also in communication with said inflatable profile, may be used for partially releasing the pressure in the inflatable profile and thus partially reducing the force on the wafers. Control valve 24 may be activated by hand (turned on and off) or by an auxiliary valve (connecting the auxiliary valve to the profile). A switching valve 22 controls the supply of pressurized medium, which may be gaseous or liquid.

Holding device 1 or an external auxiliary pressure supply device 20 may comprise a reservoir of compressed fluid (e.g. air) or a compressor 21. The reservoir for compressed fluid and/or the fuel tank for the compressor 21 (electrical power or a combustible fuel) is refilled in a separate station. The compressed fluid or gas may be refilled as the holding device is placed in the wire saw.

In an alternate embodiment the holding device 1 comprises a second inflatable (deflatable) profile, which is e.g. arranged at the bottom of said support structure 4, e.g. container. The second inflatable profile is in pneumatic or hydraulic communication with said first inflatable profile, which forms the holding member 3 or which acts on the holding member 3. The second inflatable profile is adapted as to abuttingly receive the wafer arrangement 7, when brought into the holding device 1. Due to its weight the wafer arrangement 7 exerts a pressure onto the second inflatable profile. The pressure causes the second inflatable profile to deflate (i.e. the second inflatable profile is compressed) and the fluid or gas is forced into the first inflatable profile at the same time. The first inflatable profile inflates, thereby pressing against the wafers. A one-way valve may be provided to prevent the fluid from flowing back as the individual wafers are subsequently removed and the overall weight of the wafer arrangement 7 is reduced. The inflatable profile may spring back to its inflated shape (e.g. by actuating a valve or applying a vacuum) once all wafers have been removed and an auxiliary valve is opened.

Such an embodiment is the pneumatic or hydraulic analogue to the embodiments of Fig. 5, 6 and 7. It is of course also possible to have an electronic transmission chain. A sensor - contact sensor or contactless sensor - detects, a wafer arrangement 7 which is moved into the receiving space 2 or reaches a receiving position. A signal generated by the sensor may activate an electrically powered moving means, e.g. a motor, a solenoid, compressor etc., causing the holding members 3 to move into the holding/releasing position. The basic idea of all these embodiments is to make the holding members 3 automatically moving into the holding position, when the wafer arrangement 7 (the wafers are already cut) is received by the holding device 1. No manual handling by an operator is required.

Fig. 9 illustrates the method of receiving a wafer arrangement 7 from a processing device 25, particularly a cutting device. In a first step the holding device 1 is brought in a position relative to the processing device 25 (indicated by the upwardly directed arrow at the bottom of Fig. 9) as to receive the wafer arrangement 7. In a second step the holding members 3 are - automatically or manually - forced into the holding state, thereby applying a force against the wafers. The wafers are now securely fixed. Subsequently, the wafer arrangement 7 being fixed by the holding device 1 is detached from the processing device 25. I.e. the wafers are clamped before unloading the wafer arrangement 7 from the processing device 25. The method guarantees a safe transport from one processing step to another.

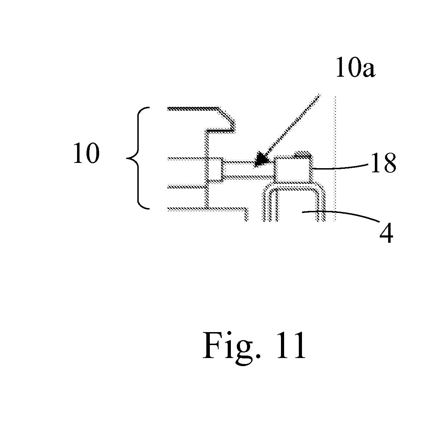

Fig. 11 illustrates a laterally extending member 10a of the carrier 10 (arrow, also shown e.g. in fig. 8) that delimits the movement of the wafer block into the receiving space 2. In this way the pressure on the bottom side of the wafers can be delimited. Moreover, also the pressure of the holding members is delimited.

### List of reference signs

- 1 -: holding device
- 2 -: receiving space
- 3 -: holding member
- 4 -: support structure
- 5 -: contact member
- 6 -: lever
- 7 -: arrangement of a plurality of wafers
- 8 -: glass plate
- 9 -: fixture attachment
- 10 -: carrier of the wafers
- 10a -: extending member
- 11 -: spring means
- 12 -: spring means
- 13 -: adjusting knob
- 14 -: block
- 15 -: contact member
- 16 -: lever/crank
- 17 -: transmission rod
- 18 -: stop for the carrier 10
- 19 -: pins
- 20 -: pressure supply means
- 21 -: compressor
- 22 -: control valve
- 23 -: pressure control valve
- 24 -: control valve
- 25 -: processing device
- 26 -: guide rails
- 27 -: tensioning rod
- 28 -: mounting surface
- 29 -: support base

- 30 -: wire guide roll

- 31 -: cutting wire

## Claims

1. Holding device (1) for holding an arrangement (7) of a plurality of wafers, the holding device (1) comprises:
a receiving space (2) for receiving said arrangement (7) of a plurality of wafers,
at least two holding members (3), which are arranged on opposite sides of said receiving space (2), and
a support structure (4), to which the holding members (3) are arranged,
wherein at least one of the holding members (3) is movable with respect to said support structure (4) to bring the holding device (1) from a releasing state to a holding state, in which a holding force is applied by the holding members (3) against the side edges of said wafers.

2. Holding device according to claim 1, wherein the holding device (1) comprises a transmitting means (5, 6; 15, 16, 17) which is in co-acting communication with a holding member (3) and adapted to co-act with the arrangement (7) of a plurality of wafers to cause the holding member (3) to apply the holding force against the side edges of said wafers, when the arrangement (7) of a plurality of wafers is brought into said receiving space (2).

3. Holding device according to claim 2, wherein the transmitting means comprises a contact member (5; 15) which is adapted to contact the arrangement (7) of a plurality of wafers, when the arrangement (7) of a plurality of wafers is brought into said receiving space (2) and wherein the contact member (5; 15) is preferably made of a soft and/or elastic or plastic material.

4. Holding device according to claim 3, wherein said transmitting means is adapted to transmit a force applied onto the contact member (5; 15) by the arrangement (7) of a plurality of wafers onto the holding member (3) and wherein the transmitting means preferably comprise a mechanical and/or pneumatic and/or hydraulic transmission path.

5. Holding device according to any of claims 3 to 4, wherein said contact member (5) is arranged in the bottom region of said holding device (1) for contacting the lower side of the wafers, when the arrangement (7) of a plurality of wafers is received by said receiving space (2) or wherein said contact member (15) is arranged laterally in the top region of the holding device (1) for contacting a carrier (10) of the arrangement (7) of a plurality wafers, when the arrangement (7) of a plurality wafers is received by said receiving space (2).

6. Holding device according to any of claims 2 to 5, wherein said transmitting means comprise a lever (6; 16) which is pivotably mounted on the support structure (4), and wherein preferably the lever (6) is L-shaped.

7. Holding device according to any of claims 2 to 6, wherein the transmitting means is adapted to be forced into the releasing state preferably by gravity or by spring means (11; 12), when there is no arrangement (7) of a plurality of wafers received by said receiving space (2).

8. Holding device according to claim 7, wherein the transmitting means communicates with a spring means (11; 12), forcing the transmitting means into the releasing position, when there is no arrangement (7) of a plurality wafers received by said receiving space (2).

9. Holding device according to any of the preceding claims, wherein the holding device (1) comprises a fixing means for fixing the transmitting means or the holding members (3) in the holding state, or wherein the holding device (1) comprises a counteracting means (19) for partially counteracting the holding force applied by the holding members (3) against the side of the wafers and wherein preferably the counteracting means (19) is in direct communication with the transmitting means.

10. Holding device according to any of the preceding claims, wherein the holding device (1) further comprises a stop for limiting the receiving movement of the arrangement (7) of a plurality of wafers into the receiving space (2) preferably by abutting against a carrier (10) of the arrangement (7) of a plurality of wafers or wherein the support structure (4) is a container for enclosing the wafers.

11. Holding device according to any of the preceding claims, wherein the holding members (3) are formed from a soft, preferably elastic or plastic material and/or wherein the holding members (3) are formed from a roller, which is rotatable about its axis.

12. Holding device according to any of the preceding claims, wherein at least one of the holding members (3) is part of an inflatable means, and/or wherein preferably the contact member (5) of the transmitting means is part of a second inflatable means, which is in pneumatic or hydraulic communication with said inflatable means forming the holding member (3).

13. Method of receiving an arrangement (7) of a plurality of wafers from a processing device, particularly a cutting device for cutting a plurality of wafers from a block (15), using a holding device (1) according to one of the preceding claims, wherein the method comprises the steps of:
bringing the holding device (1) in a position relative to the processing device as to receive the arrangement (7) of a plurality of wafers,
bringing the holding members (3) into the holding state, thereby applying a force against the sides of the wafers, and
detaching the arrangement (7) of a plurality of wafers from the processing device.

14. Method according to claim 13, wherein the holding device (1) is brought in contact with a carrier (10) of the arrangement (7) of a plurality of wafers during receiving of said arrangement (7) by the holding device (1).

15. Method of treating of wafers in a holding device (1) according to any of the claims 1 to 12, wherein the wafers are held by holding members (3) of the holding device (1), thereby applying a force against the sides of the wafers and wherein the holding force is partially released before or during the treating process.
